# EUROPEAN PATENT APPLICATION

(11) **EP 4 304 086 A1**
(43) Date of publication of application: **10.01.2024**
(21) Application number: 23306141.5
(22) Date of filing: 06.07.2023

(54) **CIRCUIT FOR DUAL POWER SUPPLY SYSTEM AND DUAL POWER SUPPLY SYSTEM**

(30) Priority: 08.07.2022 CN 202221766962 U
(71) Applicant: Schneider Electric Industries SAS, 92500 Rueil-Malmaison (FR)
(72) Inventor: RUAN, Xiaobo, Shanghai, 201203 (CN); BI, Baoyun, Shanghai, 201203 (CN); WU, Wei, Shanghai, 201203 (CN); ZHAO, Chaomin, Shanghai, 201203 (CN); PENG, Hao, Shanghai, 201203 (CN)
(74) Representative: Manitz Finsterwald Patent- und Rechtsanwaltspartnerschaft mbB

(57) **Abstract**

The present disclosure relates to a circuit for a dual power supply system and a dual power supply system. A first input end of first and second logic control units of a circuit is coupled to a first voltage source via first and second switch units, respectively. The first logic control unit turns on a first driving circuit in response to a first switch unit being turned on and a received first position control signal being at a first level, so that one of a first power supply and a second power supply of the dual power supply system is turned on. The second logic control unit turns on a second driving circuit in response to the second switch unit being turned on and a received second position control signal being at a first level, so that the other one of the first power supply and the second power supply of the dual power supply system is turned on. The first switch unit is turned off in response to the second position control signal being at the first level. The second switch unit is turned off in response to the first position control signal being a first level. Thus, with an interlocking design of signals, it can be ensured that no interruption occurs during power supply switching.

## Description

### FIELD

Embodiments of the present disclosure generally relate to the field of switching device, and more specifically, to a circuit for dual power supply system and dual power system.

### BACKGROUND

In the dual power supply system, an electromagnet, as a switch driving mechanism, is controlled by a power control processor. The electromagnet determines a drive direction so the core of the controller is the control of the electromagnet. Electromagnet energization is controlled by a switching device such as an Insulated Gate Bipolar Transistor (IGBT). The switching device is turned on and turned off by a control signal from a microprocessor MCU.

However, there are various kinds of electromagnetic interference in the industrial field, which may cause interference to the MCU signal. Thus, a control circuit receives the control signal turning on two electromagnets at the same time. As a result, malfunction of the dual power supply system may occur. Therefore, it is a challenge for a designer to design the control circuit resistant to signal interference.

### SUMMARY

Embodiments of the present disclosure provide a control circuit having a control signal interlocking function to at least partially address the above and other potential problems with the prior art.

In a first aspect of the present disclosure, there is provided a circuit for a dual power supply system comprising a first power supply and a second power supply. The circuit comprises a first power supply and a second power supply, wherein, the circuit comprises a first logic control unit, a first switch unit, a second logic control unit, a second switch unit, a first driving circuit and a second driving circuit. The first driving circuit includes a first switch and is configured to be turned on in response to the first switch being closed such that one of the first power supply and the second power supply is turned on; and the second driving circuit includes a second switch and is configured to be turned on in response to the second switch being closed such that the other one of the first power supply and the second power supply is turned on. A first input end of the first logic control unit is coupled to a first voltage source via the first switch unit, and a second input end of the first logic control unit is configured to receive a first power supply control signal, and an output end of the first logic control unit is coupled to a control end of the first switch of the first driving circuit. A first input end of the second logic control unit is coupled to the first voltage source via the second switch unit, and a second input end of the second logic control unit is configured to receive a second power supply control signal, and an output end of the second logic control unit is coupled to a control end of the second switch of the second driving circuit. The first switch unit is configured to be turned off in response to the second power supply control signal being at a first level, and the second switch unit is configured to be turned off in response to the first power supply control signal being at a first level. The first logic control unit is configured to output a first switch closing signal to close the first switch in response to the first switch unit being turned on and the first power supply control signal being a first level, and the second logic control unit is configured to output a second switch closing signal to close the second switch in response to the second switch unit being turned on and the second power supply control signal being at a first level.

According to an embodiment of the present disclosure, the control circuit includes a first branch and a second branch. The first branch comprises a first logic control unit, a first switch unit and a first driving circuit, and the second branch comprises a second logic unit, a second switch unit and a second driving circuit. The first switch unit and the second switch unit are configured to be in an off state before receiving the feedback signal. At this time, when the first logic control unit logically ANDs a signal from a voltage source at the first input end and the first power supply control signal at the first level at the second input end so as to input the first switch closing signal to the first switch to close the first switch, the power supply changeover switch is driven to a first position to turn on a preset power supply to a load circuit in cooperation with the subsequent logic operation. Meanwhile, upon receiving the first power supply control signal, the second switch unit in the second branch receives a feedback signal associated with the first power supply control signal from the first branch, and the second switch unit opens in response to receiving the feedback signal at the first level. At this time, the second switch unit is turned off to disconnect the connection between the second logic control unit and the voltage source, so that the second logic control unit cannot output the high-level second switch closing signal to the second switch regardless of whether the second power supply control signal at the first level is received. That is, the input of the first power supply control signal prevents the second switching from being closed to drive the power supply changeover switch. Correspondingly, the input of the second power supply control signal will also make it impossible for the second switch to be closed to drive the power supply changeover switch, whereby an interlocking of the first branch with the second branch is achieved. In this way, interlocking of the first branch with the second branch is achieved by setting the feedback signal such that the control circuit is not disturbed by signals received from the other branch, increasing the resistance of the control circuit to signal disturbances. It should be understood that the feedback signal is associated with the power supply control signal, meaning that the feedback signal has a particular relationship to the power supply control signal, e.g., the feedback signal may have the same level as the power supply control signal or an opposite level.

In some embodiments, a control end of the second switch unit is coupled to the second input end of the first logic control unit; and a control end of the first switch unit is coupled to the second input end of the second logic control unit. In such an embodiment, by means of this connection, when the first power supply control signal is input to the second input end of the first logic control unit, the first power supply control signal is also directly input to the control end of the second switch unit as the feedback signal. Accordingly, when the second power supply control signal is input to the second input end of the second logic control unit, the second power supply control signal is also directly input to the control end of the first switch unit as a feedback signal.

In some embodiments, the control end of the second switch unit is coupled to the output end of the first logic control unit and is configured to be turned off in response to receiving the first switch closing signal; and the control end of the first switch unit is coupled to the output end of the second logic control unit and is configured to be turned off in response to receiving the second switch closing signal. In such an embodiment, by this connection, when the first logic control unit outputs the first switch closing signal, the first switch closing signal can be input as a feedback signal to the control end of the second switch unit. Correspondingly, when the second logic control unit outputs the second switch closing signal, the second switch closing signal can be input as a feedback signal to the control end of the first switch unit.

In some embodiments, the control end of the second switch unit is connected in series with the first switch and is configured to be turned off in response to the first switch being closed; and the control end of the first switch unit is connected in series with the second switch and is configured to be turned off in response to the second switch being closed. In such an embodiment, by means of this connection, when the first switch is turned on, the circuit in which it is located is turned on, and the feedback signal is generated and input to the control end of the second switch unit. Accordingly, when the second switch is turned on, the circuit in which it is located is turned on, and a feedback signal is generated and input to the control end of the first switch unit.

In some embodiments, the first logic control unit comprises an optocoupler, a first NPN-type transistor, a first resistor, a second resistor, a third resistor and a fourth resistor. A first input end of the optical coupler is coupled to a first end of the fourth resistor, and a second end of the fourth resistor is coupled to the first switch unit, and a second input end of the optical coupler is coupled to a collector electrode of the first NPN-type transistor, and an output end of the optical coupler is coupled to the first switch, and a base end of the first NPN-type transistor is coupled to a first end of the first resistor and a first end of the second resistor, and an emitter electrode of the first NPN-type transistor is coupled to a first end of the third resistor, and a second end of the first resistor is coupled to a second input end of the first logic control unit, and a second end of the second resistor is grounded, and a second end of the third resistor is grounded.

In such an embodiment, when the first power supply control signal is input to the base electrode of the first NPN-type transistor through the first resistor, the base electrode of the first NPN-type transistor is turned on so that the optical coupler operates to output the first power supply control signal, thereby implementing a logical AND operation.

In some embodiments, the emitter electrode of the first NPN-type transistor is coupled to a control end of the second switch unit. In such an embodiment, when the first NPN-type transistor is turned on, the emitter outputs a signal which is input as feedback to the control end of the second switch unit. In this way, by arranging the output of the feedback signal at an input side of the optocoupler, achieving the signal isolation and improving the stability of the circuit.

In some embodiments, the first switch unit includes a P-channel depletion mode MOSFET, a second NPN-type transistor, a third NPN-type transistor, a fifth resistor, a sixth resistor, and a seventh resistor. A source electrode of the P-channel depletion mode MOSFET is coupled to the first voltage source and a first end of the seventh resistor. A drain electrode of the P-channel depletion mode MOSFET is connected to the first logic control unit, and a gate electrode of the P-channel depletion mode MOSFET is coupled to the second end of the seventh resistor, and the collector electrode of the second NPN type transistor and the collector electrode of the third NPN type transistor. A base electrode of the second NPN-type transistor is coupled to an end of a fifth resistor and a first end of a sixth resistor. An emitter electrode of the second NPN transistor is coupled to the base electrode of the third NPN transistor. An emitter electrode of the third NPN-type transistor is grounded, and the second end of the sixth resistor is grounded. A second end of the fifth resistor is coupled to the control end of the first switch unit.

In such an embodiment, the second NPN-type transistor and the third NPN-type transistor form a Darlington tube, and when the feedback signal is input into the second NPN-type transistor, the second NPN-type transistor is turned on, thereby controlling the P-channel depletion mode MOSFET to be turned off and realizing an operation logic that a normally-closed switching device is turned off under control.

In some embodiments, the first logic control unit is further configured to turn off the first switch in response to the first switch unit being turned off. Alternatively or additionally, the first logic control unit is further configured to turn off the first switch in response to the first power supply control signal being at the second level. It should be understood that the first level may also be a low level and the second level a high level, and in this case, corresponding devices can be added or replaced according to aspects of the present disclosure to achieve the same logical operation.

In some embodiments, the circuit for a dual power supply system further comprises a power supply changeover switch. The first driving circuit further includes a first actuator configured to drive the power supply changeover switch to turn on one of the first power supply and the second power supply in response to the first switch being closed. The second driving circuit further comprises a second actuator configured to drive the power supply changeover switch to turn on the other of the first power supply and the second power supply in response to the second switch being closed. In such an embodiment, power switch of the dual power supply system can be achieved by driving of the actuator.

In a first aspect of the present disclosure, there is provided a dual power supply system. The dual power supply system comprises: a first power supply, a second power supply, and a circuit for a dual power supply system described in accordance with a first aspect of the present disclosure. The circuit for a dual power supply system is configured to selectively turn on the first power supply or the second power supply

It will be appreciated that the description and advantages of the circuit for a dual power supply system according to the first aspect of the present disclosure apply equally to the dual power supply system of the second aspect of the present disclosure.

According to embodiments of the present disclosure, the resistance of a circuit for a dual power supply to signal interference may be improved by the interlocking design of the control signal.

### BRIEF DESCRIPTION OF THE DRAWINGS

Through the following detailed description with reference to the accompanying drawings, the above and other objectives, features, and advantages of example embodiments of the present disclosure will become more apparent. Embodiments of the present disclosure will be described by way of example and non-limitation in the accompanying figures, wherein:
FIG. 1 illustrates an overall schematic diagram of a circuit for a dual power supply system according to the prior art;
FIG. 2 illustrates an overall schematic diagram of a circuit for a dual power supply system according to an exemplary embodiment of the present disclosure;
FIG. 3 illustrates a detailed structural diagram of a circuit for a dual power supply system according to an exemplary embodiment of the present disclosure.

### DETAILED DESCRIPTION OF EMBODIMENTS

The principles of the present disclosure will be described with reference to various exemplary embodiments shown in the drawings. It should be understood that the description of these embodiments is merely intended to enable those skilled in the art to better understand and to further practice the present disclosure, and is not intended to limit the scope of the present disclosure in any way. It should be noted that where possible, similar or identical reference numbers may be used throughout the drawings and may indicate similar or identical functionality. Those skilled in the art will readily recognize from the following description that alternative embodiments of the structures and methods illustrated herein may be employed without departing from the principles of the invention described herein.

As used herein, the term "includes" and its variants are to be read as open-ended terms that mean "includes, but is not limited to". The term "based on" is to be read as "based at least in part on". The terms "one example embodiment" and "one embodiment" are to be read as "at least one example embodiment". The term "a further embodiment" is to be read as "at least a further embodiment". The terms "first", "second" and so on can refer to same or different objects. The following text also can include other explicit and implicit definitions. Definitions of terms are consistent throughout the specification unless the context clearly dictates otherwise.

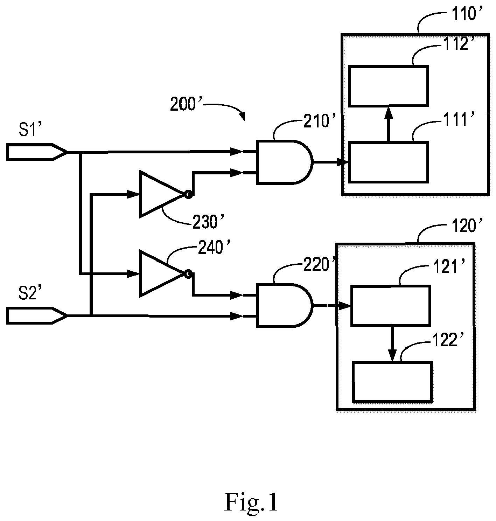

As discussed above, conventionally, when the coils in both paths of the dual power supply system are turned on at the same time due to a malfunction or a fault, a short circuit of two path of the power supply system occurs, attributing to a safety accident. In this regard, a conventional control circuit prevent simultaneous output of two power supplies through the cooperation of inverters and AND gates. However, when the control circuit is disturbed by another control signal during conduction of one way, the conducting circuit may be interrupted and fail. A control circuit in the prior art will be described in detail with reference to FIG. 1.

FIG. 1 illustrates a schematic diagram of a circuit for a dual power supply system according to the prior art. The control circuit is used to drive the power supply changeover switch to the first position or the second position so that one of the first power source and the second power source of the dual power supply system is connected to the load circuit. The control circuit includes a first driver circuit 110 'and a second driver circuit 120'. The first driving circuit 110' comprises a first switch 111' and the second driving circuit 120' comprises a second switch 121'. The control circuit 200' is adapted to control to turn on and/off the first driving circuit 110' and the second driving circuit 120' and comprises a first logical AND unit 210' adapted to control the first switch 111' and a second logical AND unit 220' adapted to control the second switch 121'. A first input end of the first logical AND unit 210' receives a first power supply control signal S1' for controlling the first switch 111', and a second input end of the first logical AND unit 210' is coupled to an output end of a first inverter 230'. An input end of the first inverter 230' is configured to receive a second power supply control signal S2' for controlling the second switch 121'. In contrast, a first input end of the second logical AND unit 220' receives a second power supply control signal S2' for controlling the second switch 121', and a second input end of the second logical AND unit 220' is coupled to an output end of a second inverter 240'. The input end of the second inverter 240' is configured to receive the first power supply control signal S1'.

In the circuit shown in FIG. 1, when the first power supply control signal S1' and the second power supply control signal S2' are both at low level, both the first inverter 230' and the second inverter 240' output a high signal. At this time, input signals received by the first logic AND unit 210' and the second logic AND unit 220' are different, so that both the first driving circuit 110' and the second driving circuit 120' are turned off. When the first power supply control signal S1' goes high, both two input signals received by the first logical AND unit 210' are high, and after logical AND operation, a high control signal is output to make turn on the first switch 111'. However, during the conduction of the first switch 111', the two input signals are high at the same time due to, for example, a delay in the change of the input signal or signal interference, i. e., the second power supply control signal S2' becomes high, so that the first inverter 230' inputs a low level signal such that the first logic AND unit 210' no longer outputs a high level signal. As a result, the first switch 111' turns off, causing an undesired interruption and thereby losing control of the dual power supply system.

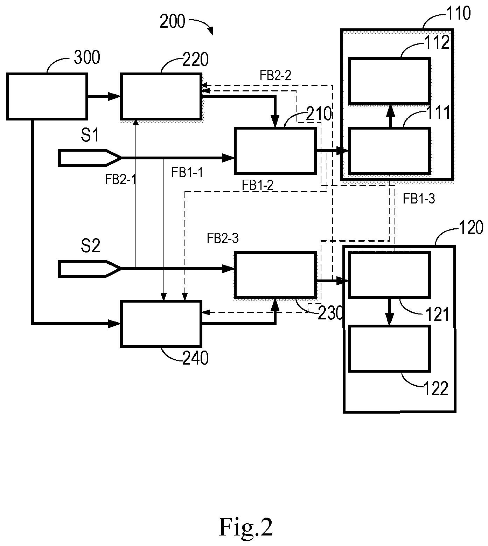

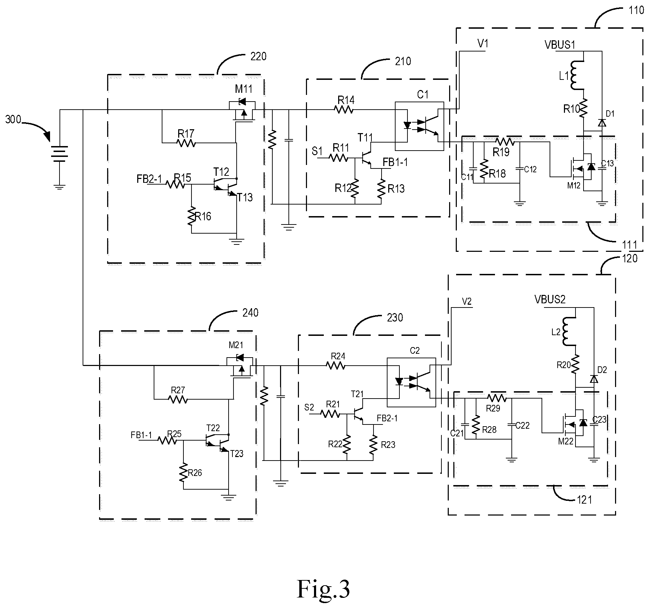

In this regard, the present disclosure proposes a control circuit having a control signal interlocking function, with which, when one power source is turned on, there is no signal disturbance from the other path, avoiding a control failure for the dual power supply system. The structure and operation principle of the control circuit according to the present disclosure will be described in detail with reference to FIGS. 2 and 3.

FIG. 2 illustrates a schematic diagram of a circuit for a dual power supply system according to an exemplary embodiment of the present disclosure. As shown in FIG. 2, the dual power supply system includes the first power supply and the second power supply. The circuit 200 includes a first logic control unit 210, a first switch unit 220, a second logic control unit 230, a second switch unit 240, a first driving circuit 110 and a second driving circuit 120, and a power supply changeover switch. The power supply changeover switch is configured to be driven to the first position or the second position to cooperate with a subsequent logic operation to connect one of the first power source or the second power source into the load circuit.

The first driving circuit 110 includes a first switch 111 and a first actuator 112 (e.g., an electromagnet), and is configured to be turned on in response to the first switch 111 being closed such that the second actuator 122 drives the power supply changeover switch to turn on one of the first power supply and the second power supply. The second driving circuit 120 includes a second switch 121 and a second actuator 122 (e.g., an electromagnet), and is configured to be turned on in response to the second switch 121 being closed such that the second actuator 122 drives the power supply changeover switch to turn on the other of the first and second power sources. The first input end of the first logic control unit 210 is coupled to the first voltage source 300 through the first switch unit 220. The first logic control unit 210 comprises a second input end for receiving a first power supply control signal S1. The output end of the first logic control unit 210 is coupled to the first switch 111. The first input end of the second logic control unit 230 is coupled to the first voltage source 300 through the second switch unit 240. The second logic control unit 230 further comprises a second input end configured to receive a second power supply control signal S2. The output end of the second logic control unit 230 is coupled to the second switch 121. The first switch unit 110 is configured to be turned off in response to the second power supply control signal S2 being at a first level (e.g., a high level), and the second switch unit 240 is configured to be turned off in response to the first power supply control signal S1 being a first level. The first logic control unit 210 is configured to output the first switch closing signal to close the first switch 111 in response to the first switch unit 220 being turned on and the first power supply control signal being a first level. Further, the second logic control unit 230 is configured to output the second switch closing signal to close the second switch 121 in response to the second switch unit 240 being turned on and the second power supply control signal being at a first level.

The circuit according to the present disclosure may be, for example, part of an Automatic Transfer Switching Equipment (ATSE), and the power supply changeover switch of the present disclosure may be a contact structure in the ATSE, but is not limited thereto. One end of the ATSE is connected to a load and the other end is connected to a common power source and a backup power source (e.g., the first power source and the second power source). In a normal operating state, the ATSE may turn on the common power supply to power the load circuit. When an abnormality occurs in a circuit in which the common power supply is located, the load is automatically connected to the backup power supply through a dual power supply changeover switch to continue the operation of the load. It should be understood that the circuit of the present disclosure may be part of a particular device or may be independent of other devices.

Control of the power switching process is performed by a power control processor (e.g., MCU) based on certain logic operations. When supplying power to the load, the MCU issues a power supply control signal (e.g., the first power supply control signal) to drive the power supply changeover switch for action. Then, the common power source is powered on through a power selecting operation to enter a normal operation. After entering the working state, the power control processor automatically detects circuits of the common power supply and the circuit of the backup power supply. When detecting a sudden circuit abnormality (loss of voltage, overvoltage, undervoltage, phase interruption, frequency deviation, etc.) of the common power supply, the power control processor no longer issues the power supply control signal for the common power source to disconnect the common power source, and issues the power supply control signal (e.g., the second power supply control signal) for the backup power source to drive the power supply changeover switch to connect the backup power source to the load circuit so as for switching from the common power source to the backup power source.

In the embodiment shown in FIG. 2, the first logic control unit 210 and the second logic control unit 230 are configured to perform the logical AND operation on the signal at the first input end and the signal at the second input end, and output high-level first and second switch closing signals to close the first switch and the second switch when the signal at the first input end and the signal at the second input end are both high. In contrast, the first logic control unit 210 and the second logic control unit 230 are further configured such that the logic control unit does not output a high-level signal when the signal at either of the first input end and the second input end is low, i. e., when the power supply control signal is low or the switch unit is turned off. That is, when the first switch unit 220 is turned off and/or the first power supply control signal S1 is at the second level (e.g., low level), the first logic control unit 210 does not output the first switch closing signal at the high level, thereby turning off the first switch 111. Likewise, it is configured that the second logic control unit 230 does not output the high-level second switch closing signal in response to that when the second switch unit 240 is turned off and/or the second power supply control signal S2 is at the second level (e.g., low level), thereby turning off the second switch 121.

Since the first input end of the first logic control unit 210 is coupled to the first voltage source 300 through the first switch unit 110, the signal at the first input end of the first logic control unit 210 is high when the first switch unit 220 is closed, and is low when the first switch unit 220 is turned off. Accordingly, since the first input end of the second logic control unit 230 is coupled to the first voltage source 300 through the second switch unit 240, the signal at the first input end of the second logic control unit 230 is high when the second switch unit 210 is closed, and is low when the second switch unit 240 is turned off. For example, when the first switch unit 110 is closed, the signal at the first input end of the first logic control unit 210 is high, and if the first power supply control signal received at the second input end is also high, the first logic control unit 210 performs logical ANDs on the signal at the first input end and the signal at the second input end, and outputs the high-level first switch closing signal to the control end of the first switch 111 in response to the signals at both input ends being high. In contrast, when the first switch unit 110 is turned off, the signal at the first input end of the first logic control unit 210 is low, and if the first power supply control signal received at the second input end is high, the first logic control unit 210 performs logical ANDs on the signal at the first input end and the signal at the second input end, and does not output the high-level first switch closing signal. The control principle for the first switch 111 is equally applicable to that for the second switch 121.

As discussed above, the logic control unit controls based on the closed and turned-on state of the switch unit and the power supply control signal. In order to achieve the interlocking of the control signals, it is necessary to associate the closed and turned-on state of the switch unit with the power supply control signal at the other path, i. e., the first switch unit 220 is turned off in response to the second power supply control signal S2 being at the first level and the second switch unit 240 is turned off in response to the first power supply control signal S1 being at the first level. In this regard, according to an embodiment of the present disclosure, first feedback signals FB1-1, FB1-2, FB1-3 (collectively, FB1) associated with the first power supply control signal are input to the second switch unit 240, and second feedback signals FB2-1, FB2-2, FB2-3 (collectively, FB2) associated with the second power supply control signal S2 are input to the control end of the first switch unit 220. The association of the control for the first switch 111 with the second power supply control signal and the association of the control for the second switch 121 with the first power supply control signal is achieved by the control of the feedback signal.

In some embodiments, the second input end of the first logic control unit 210 is coupled to the control end of the second switch unit 240. By this connection manner, when the first power supply control signal S1 is input to the second input end of the first logic control unit 220, the first power supply control signal S1 is simultaneouS1y input to the control end of the second switch unit 240 as the first feedback signal FB1-1, for example, by shunting. Since the first feedback signal FB1-1 is homologous to the first power supply control signal S1, when the first power supply control signal S1 is high, the first feedback signal FB 1-1 is also high. Accordingly, the second input end of the second logic control unit 230 is coupled to the control end of the first switch unit 220. When the second power supply control signal S2 is input to the second input end of the second logic control unit 230, the second power supply control signal S2 is directly input to the control end of the first switch unit 230 as a feedback signal FB2-1, for example, by shunting. Since the second feedback signal FB2-1 is homologous to the second power supply control signal S1, when the second power supply control signal S2 is high, the second feedback signal FB2-1 is also high.

In other embodiments, the control end of the second switch unit 240 is coupled to the output end (shown in dashed lines) of the first logic control unit 210. When the first logic control unit 210 outputs the first switch closing signal, the first switch closing signal can be input to the control end of the second switch unit as the first feedback signal FB 1-2. In the case where the first driving circuit 110 is turned on, the first power supply control signal S1 is high, and the first switch closing signal outputted from the first logic control unit 210 is also high. Thus, the level of the first feedback signal FB1-2 reflects the level of the first power supply control signal S1. Accordingly, the control end of the first switch unit 240 is coupled to the output end (shown in dotted lines) of the second logic control unit 210. When the second logic control unit 230 outputs the second switch closing signal, the second switch closing signal can be input to the control end of the second switch unit as the second feedback signal FB2-2. In the case where the second driving circuit 120 is turned on, the second power supply control signal S2 is high, and the second switch closing signal outputted from the second logic control unit 230 is also high. Thus, the level of the second feedback signal FB2-2 reflects the level of the second power supply control signal S2.

In still other embodiments, the control end of the second switch unit 240 is connected in series with the first switch 111 and is configured to be turned off in response to the first switch 111 being closed (shown in dashed lines). The control end of the first switch unit 220 is connected in series with the second switch 121 and is configured to be turned off in response to the second switch 111 being closed (shown in dotted lines). When the first switch 111 is turned on, the circuit on which the first switch 111 is located is conducted, and the feedback signal FBI-3 is generated and input to the control end of the second switch unit 240. On the contrary, when the second switch 121 is turned on, the circuit on which the second switch 121 is located is conducted, and the feedback signal FB2-3 is generated and input to the control end of the first switch unit 220. In such an embodiment, the first switch 111 may include a first end coupled to a first coil, a second end coupled to ground, and a control end coupled to the output end of the first logic control unit 230, and either the first end or the second end of the first switch 111 may be coupled to the control end of the second switch unit 240 (which may be collectively referred to as the control end of the second switch unit 240 being connected in series with the first switch 111). That is, the feedback signals FB1-3 and FB2-3 may be output from any end of the first switch 111 and the second switch 121. In such an embodiment, when the power supply control signal is high and enables the switch to be closed, the circuit in which the switch is located is conducted and the signal extracted from both ends of the switch is also high.

It will be appreciated that the arrangement of the above three feedback signals can be applied in an alternative manner and can also be used in parallel after processing as required to improve stability.

The process by which the dual power supply system switches from the first power supply to the second power supply (e.g., the ASTE switches from the common power supply to the backup power supply) will be described with reference to FIG. 2.

In order to turn on the first driving circuit 110, the power control processor issues the high level first power supply control signal S1 to the second input end of the first logic control unit 210. The first switch unit 210 and the second switch unit 230 are configured to be in a closed state before receiving the feedback signal. At this time, the signal at the first input end of the first logic control unit 210 is high. Thereafter, the first logic control unit 210 performs a logical AND operation on the signal at the first input end and the signal at the second input end, and inputs the high-level first switch closing signal from the output end to the first switch 111 to close the first switch 111 in response to the signals at both input ends being high, so that the first actuator 112 for driving the power supply changeover switch in the load circuit is powered on. Thus, the first actuator 112 drives the power supply changeover switch to the first position so that one of the first power source and the second power source is turned on and operates normally. Meanwhile, when the control circuit 200 receives the first power supply control signal S1 which is high, the feedback signal FB1 (including FB1-1, FB1-2 or FB1-3) received by the control end of the second switch unit 240 is high, and the second switch unit 240 is turned off in response to the control of the feedback signal FB1. At this time, the second switch unit 240 is turned off to disconnect the second logic control unit 230 from the first voltage source 300, so that the signal at the first input end of the second logic control unit 230 is at a low level. Therefore, regardless of whether the second power supply control signal S2 at this time is high or not, the second logic control unit 230 does not output a high second switch closing signal to the control end of the second switch 121, and thus the second switch 121 of the second power supply is not closed.

When detecting an abnormality (loss of voltage, overvoltage, undervoltage, phase interruption, frequency deviation, etc.) on the circuit wherein the turned on power supply is located, the power control processor (e.g., MCU) turns off the first power supply control signal S1 and outputs the second power supply control signal S2 to the second input end of the second logic control unit 230 in an attempt to switching from the turned-on power source to the other power source. At this point, since the first power supply control signal S1, is no longer high, the first feedback signal FBI associated with the first power supply control signal S1 is no longer high, either. As a result, the second switch unit 240, which was turned off under the control of the high-level first feedback signal FBI, is closed out of the control of the high-level signal, thereby unlocking the second driving circuit 120. At this time, the signal at the first input end of the second logic control unit 230 is high because the second switch unit 240 is closed again. The second logic control unit 230 performs a logical AND operation on the signal at the first input end and the second power supply control signal S2 at the second input end, and inputs the high-level second switch closing signal from the output end to the second switch 121 to close the second switch 121 in response to both the signal at the first input end and the signal at the second input end being high, so that the second actuator 122 for driving the power supply changeover switch is powered on. Thus, the second actuator 122 drives the power supply changeover switch to switch to the second position, so that the other of the first power source and the other power source is turned on. Thus, the switch from the turned-on power supply to another power supply is completed. Meanwhile, upon receiving the high-level second power supply control signal S2, the second feedback signal FB2 (including FB2-1, FB2-2 or FB2-3) received by the control end of the first switch unit 220 goes high, and the first switch unit 220 is turned off in response to the control of the first feedback signal FBI. At this time, the first switch unit 220 is turned off to disconnect the first logic control unit 210 from the first voltage source 300, so that the signal at the first input end of the first logic control unit 210 is at a low level. Therefore, the first logic control unit 210 does not output the high-level first switch closing signal to the control end of the first switch 111 despite that whether the first power supply control signal S1 at this time is high or not, and thus the first switch 111 of the first driving circuit 110 does not close. Thus, locking of the first driving circuit 110 by the second power supply control signal S2 is achieved.

Therefore, during the process of switching from the turned-on power supply to the other power supply in the dual power supply system, the second driving circuit 120 cannot be turned on when the first power supply control signal S1 is high, and the first driving circuit 110 cannot be turned on when the second power supply control signal S2 is high. Thereby, the interlocking between the first power supply control signal S1 for controlling the first driver circuit 110 and the second power supply control signal S2 for controlling the second driver circuit 120 is achieved. In this way, when one of the first power supply and the second power supply is in the turned-on state, the dual power supply system would not be accidentally interrupted due to erroneous transmission or signal interference of the control signal for the other power supply, thereby improving the reliability.

FIG. 3 illustrates a detailed implementation of the dual power supply system and the control circuit thereof according to an exemplary embodiment of the present disclosure. Corresponding to the configuration in FIG. 2, the circuit shown in FIG. 3 comprises the first branch and the second branch controlling the dual power supply system.

The first branch comprises the first switch unit 220 coupled to the first voltage source 300, the first logic control unit 210 and the first driving circuit 110. Specifically, the first switch unit 220 includes a first P-channel depletion type MOSFET M11, a second NPN type transistor T12, a third NPN type transistor T13, a fifth resistor R15, a sixth resistor R16, and a seventh resistor R17. A source electrode of the first P-channel depletion mode MOSFET M11 is coupled to the first voltage source 300 and a first end of the seventh resistor R17. A drain electrode of the first P-channel depletion mode MOSFET M11 is connected to a first input end of the first logic control unit 210. A gate electrode of the first P-channel depletion mode MOSFET M11 is coupled to a second end of the seventh resistor R17, a collector electrode of the second NPN transistor T12 and a collector electrode of the third NPN transistor T13. A base electrode of the second NPN transistor T12 is coupled to a first end of the fifth resistor R15 and to a first end of the sixth resistor R16. An emitter electrode of the second NPN transistor T12 is coupled to a base electrode of the third NPN transistor T13. An emitter electrode of the third NPN-type transistor T13 is grounded, and a second end of the sixth resistor R16 is grounded. A second end of the fifth resistor R15 is coupled to a control end of the first switch unit 220.

An output end of the first switch unit 220 is coupled to the first input end of the first logic control unit 210. The first logic control unit 210 comprises a first optical coupler C1, a first NPN-type transistor T11, a first resistor R11, a second resistor R12, a third resistor R13 and a fourth resistor R14, and a first input end of the first optical coupler C1 is coupled to a first end of the fourth resistor R14, and a second end of the fourth resistor R14 is coupled to the first switch unit 220, and a second input end of the first optical coupler C1 is coupled to a collector electrode of the first NPN-type transistor T11, and an output end of the first optical coupler C1 is coupled to the first switch 111, and a base electrode of the first NPN-type transistor T11 is coupled to a first end of the first resistor R11 and a first end of the second resistor R12, and an emitter electrode of the first NPN-type transistor T11 is coupled to a first end of the third resistor R13, and a second end of the first resistor R11 is coupled to a second input end of the first logic control unit 210, and a second end of the second resistor R12 is grounded, and a second end of the third resistor R13 is grounded.

In the embodiment shown in FIG. 3, the first optocoupler Cl comprises a light-emitting diode and a light-receiving phototransistor encapsulated in the same envelope. When an electrical signal is applied to the input end and the light-emitting diode is turned on to emit light, the light-receiving phototransistor receives light and then generates a photocurrent which flows out from the output end. The optical coupler couples the signal at the input end to the signal at the output end in an optical medium, and the signal is transmitted in one direction so that the isolation between an output side and an input side is achieved.

In this embodiment, when the first NPN-type transistor T11 is turned on, the second input end of the first optical coupler C 1 is grounded, and the first input end of the first optical coupler C1 is connected to the first voltage source 300, so that the voltage difference between the voltage of the first input end and the second input end is higher than a cut-off voltage of the light emitting diode. Thus, the light emitting diode emits light.

The first driving circuit 110 comprises an eighth resistor R18, a ninth resistor R19, a tenth resistor R10, a first capacitor C11, a second capacitor C12, a third capacitor C13, a first N-channel enhancement type MOSFET M12, a first coil L1, and a first diode D1. In the embodiment shown in FIG. 3, the first optical coupler Cl is a transistor optical coupler, and an emitter output end of the first optical coupler Cl is coupled to a first end of the first capacitor Cl 1, and a first end of the eighth resistor R18 and the first end of the ninth resistor R19. An collector output of the first optocoupler Cl is coupled to a first voltage Vl. A second end of the first capacitor C11, a second end of the eighth resistor R18 and a second end of the ninth resistor R19 are coupled to a first end of the second capacitor C12 and to a gate electrode of the first N-channel enhancement MOSFET M12. A second end of the second capacitor C12 is ground. A source electrode of the first N-channel enhancement type MOSFET M12 is grounded and the drain electrode of the first N-channel enhancement type MOSFET M12 is coupled to a first end of the tenth resistor R10, to an anode of the first diode D1 and to a first end of the third capacitor C13. A second end of the third capacitor C13 is grounded. A second end of the tenth resistor R10 is coupled to a first end of the first coil Ll. A second end of the first coil Ll is coupled to a cathode of the first diode Dl and to a first bus voltage VBUS1.

Oppositely, the second branch includes the second switch unit 240 coupled to the first voltage source 300, the second logic control unit 230, and the second driving circuit 120. Specifically, the second switch unit 240 includes a second P-channel depletion type MOSFET M21, a fifth NPN type transistor T22, a sixth NPN type transistor T23, a fifteenth resistor R25, a sixteenth resistor R26, and a seventeenth resistor R27. A source electrode of the second P-channel depletion mode MOSFET M21 is coupled to the first voltage source 300 and a first end of the seventeenth resistor R27. A drain electrode of the second P-channel depletion mode MOSFET M21 is connected to the first input of the second logic control unit 230. A gate electrode of the second P-channel depletion mode MOSFET M21 is coupled to a second end of the seventeenth resistor R27, to a collector electrode of the fifth NPN transistor T22 and a collector electrode of the sixth NPN transistor T23. A base electrode of the fifth NPN transistor T22 is coupled to a first end of a fifteenth resistor R25 and to a first end of the sixteenth resistor R26. An emitter electrode of the fifth NPN transistor T22 is coupled to a base electrode of the sixth NPN transistor T23. An emitter electrode of the sixth NPN-type transistor T23 is grounded, and a second end of the sixteenth resistor R26 is grounded. A second end of the fifteenth resistor R25 is coupled to a control end of the second switch unit 240.

An output end of the second switch unit 240 is coupled to a first input end of the second logic control unit 230. The second logic control unit 230 comprises a second optical coupler C2, a fourth NPN-type triode T21, an eleventh resistor R21, a twelfth resistor R22, a thirteenth resistor R23 and a fourteenth resistor R24, and a first input end of the second optical coupler C2 is coupled to a first end of the fourteenth resistor R24, and a second end of the fourteenth resistor R24 is coupled to the second switch unit 240, and a second input end of the second optical coupler C2 is coupled to a collector electrode of the fourth NPN-type triode T21, and an output end of the second optical coupler C2 is coupled to the second switch 121, and a base electrode of the fourth NPN-type transistor T21 is coupled to a first end of the eleventh resistor R21 and a first end of the twelfth resistor R22, and an emitter electrode of the fourth NPN-type transistor T21 is coupled to a first end of the thirteenth resistor R23, and a second end of the eleventh resistor R21 is coupled to a second input end of the second logic control unit 230, and a second end of the twelfth resistor R22 is grounded, and a second end of the thirteenth resistor R23 is grounded.

Further, the emitter electrode of the fourth NPN-type transistor T21 is coupled to the control end of the first switch unit 220.

The second driving circuit 120 comprises an eighteenth resistor R28, a nineteenth resistor R29, a twentieth resistor R20, a fourth capacitor C21, a fifth capacitor C22, a sixth capacitor C23, a second N-channel enhancement type MOSFET M22, a second coil L2, and a second diode D2. The second optical coupler C2 is also a transistor optical coupler, and an emitter output end of the second optical coupler C2 is coupled to the first end of the fourth capacitor C21, to a first end of the eighteenth resistor R18 and to a first end of the nineteenth resistor R29. A collector output of the second optocoupler C2 is coupled to a second voltage V2. A second end of the fourth capacitor C21, a second end of the eighteenth resistor R28 are grounded, and a second end of the nineteenth resistor R29 are coupled to an end of the fifth capacitor C22 and to a gate electrode of the second N-channel enhancement MOSFET M22. A second end of the fifth capacitor C22 is grounded. A source electrode of the second N-channel enhancement type MOSFET M22 is grounded and a drain electrode of the second N-channel enhancement type MOSFET M22 is coupled to a first end of the twentieth resistor R20, to an anode of the second diode D2 and to a first end of the sixth capacitor C23. A second end of the sixth capacitor C23 is grounded. A second end of the twentieth resistor R20 is coupled to a first end of the second coil L2. A second end of the second coil L2 is coupled to a cathode of the second diode D2 and is coupled to a second bus voltage VBUS2. It should be understood that the first voltage Vl and the second voltage V2 may be the same, and that the first bus voltage VBUS1 and the second bus voltage VBUS2 may also be the same.

It will be appreciated that the circuit composition of the first branch and the second branch is the same and that the principle of operation of the circuit shown in FIG. 3 will be described in connection with an example process in the embodiment shown in FIG. 2.

The power control processor issues the high-level first power supply control signal S1. The first power supply control signal S1 is input to the base electrode of the first NPN-type transistor T11 through the first resistor R11, and the first NPN-type transistor T11 is turned on. The first P-channel depletion mode MOSFET M11 is in a turned-on state when the gate electrode is not loaded with a voltage, and the circuit where the light emitting diode of the first optical coupler C1 is located turns on and emits light, activating a transistor output end of the first optical coupler C1 to output the first switch closing signal. The emitter output end of the first optical coupler Cl outputs the first switch closing signal to the gate electrode of the first N-channel enhancement type MOSFET M12, so that the first N-channel enhancement type MOSFET M12 is turned on, i. e., the first switch 111 is closed. At this time, the circuit in which the first coil L1 is located is turned on, that is, the first driving circuit 110 is turned on so that the first actuator 112 (for example, an electromagnet) is powered on. Thus, the first actuator 112 drives the power supply changeover switch in the load circuit to switch to the first position, thereby selectively turning on one of the first and second power sources for normal operation.

Meanwhile, when the first NPN-type transistor T11 is turned on, the feedback signal FB1-1 is generated at the emitter, and the feedback signal FB1-1 is input to the base electrode of the five NPN-type transistor T22. The input of the FB1-1 which is high enables the Darlington tube formed by the fifth NPN-type transistor T22 and the sixth NPN-type transistor T23 to be turned on and to output the high-level signal to the gate electrode of the second P-channel depletion-type MOSFET M21, so that the second P-channel depletion-type MOSFET M21 is cut off, i.e., the second optical coupler C2 is disconnected from the first voltage source 300. Therefore, whether or not the second power supply control signal S2 is at a high level at this time, the light-emitting diode of the second optical coupler C2 would not emit light, such that the high-level second switch closing signal will not be output to the gate electrode of the second N-channel enhancement type MOSFET M22, and the second N-channel enhancement type MOSFET M22 would not be closed.

When the power control processor (e.g., the MCU) turns off the first power supply control signal S1 and outputs the second power supply control signal S2 to the second input end of the second logic control unit 230 in an attempt to switching from the turned on power to the other power, since the first power supply control signal S1 is no longer high, the first feedback signal FB1-1 output from the emitter electrode of the first NPN-type transistor T11 is no longer high, either. Thus, the second P-channel depletion mode MOSFET M21, which was turned off under the control of the high-level first feedback signal FB1-1, is closed again because it is no longer under the control of the high-level signal, thereby unlocking the second driving circuit 120. At this time, since the second P-channel depletion mode MOSFET M21 is turned off again, the signal at the first input end of the second optical coupler C2 is high. The second power supply control signal S2 which is at a high level at this time is input to the base electrode of the fourth NPN-type transistor T21 through the eleventh resistor R21, and the fourth NPN-type transistor T21 is turned on. Therefore, the circuit where the light emitting diode of the second optical coupler C2 is located is turned on to emit light, thereby activating the transistor output end of the second optical coupler C2 to output the second switch closing signal. The emitter output end of the second optical coupler C2 outputs the second switch closing signal to the gate electrode of the second N-channel enhancement type MOSFET M22, so that the second N-channel enhancement type MOSFET M22 is turned on, i. e., The second switch 111 is closed. At this time, the circuit in which the second coil L2 is located is turned on, that is, the second driving circuit 120 is turned on so that the second actuator 122 (e.g., electromagnet) is powered on. Thus, the first actuator 122 drives the power supply changeover switch in the load circuit to switch to the second position, thereby selectively turning on the other of the first and second power sources for normal operation. Thus, switching from the turned-on power supply of the first power supply and the second power supply to the other power supply is completed. Meanwhile, when the fourth NPN-type transistor T21 is turned on, the feedback signal FB2-1 is generated at the emitter, and the feedback signal FB2-1 is input to the second end of the fifth resistor R15. The input of the FB2-1 which is high enables the Darlington tube formed by the second NPN-type transistor T12 and the third NPN-type transistor T13 to be turned on and to output the high-level signal to the gate electrode of the first P-channel depletion-type MOSFET M11, so that the first P-channel depletion-type MOSFET M11 is cut off, i.e., the first switch unit 220 is turned off. Therefore, whether or not the first power supply control signal S2 is high at this time, the light-emitting diode of the first optical coupler C1 does not emit light, such that the high-level first switch closing signal would not be output to the gate electrode of the first N-channel enhancement type MOSFET M12, and the first N-channel enhancement type MOSFET M12 would not be closed. Thus, locking of the first driving circuit 110 by the second power supply control signal S2 is achieved.

Thus, embodiments of the present disclosure enable reliable interlocking between control signals for a power source. Therefore, when one of the first actuator of the first driving circuit and the second actuator of the second driving circuit is powered up, the other actuator would not be accidentally powered up due to erroneous transmission of the control signal or signal interference, thereby improving the reliability of the dual power supply system.

Although claims are formulated in the present application for particular combinations of features, it should be understood that the scope of the disclosure also includes any novel feature or any novel combination of features disclosed herein either explicitly or implicitly or any generalization thereof, whether or not it relates to the same as presently claimed in any claim. The applicants hereby give notice that new claims may be formulated to such features and/or combinations of such features during the prosecution of the present application or of any further application derived therefrom.

## Claims

1. A circuit for a dual power supply system comprising a first power supply and a second power supply, wherein,
the circuit comprises a first logic control unit (210), a first switch unit (220), a second logic control unit (230), a second switch unit (240), a first driving circuit (110) and a second driving circuit (120);
wherein the first driving circuit (110) includes a first switch (111) and is configured to be turned on in response to the first switch (111) being closed such that one of the first power supply and the second power supply is turned on; and
the second driving circuit (120) includes a second switch (121) and is configured to be turned on in response to the second switch (121) being closed such that the other one of the first power supply and the second power supply is turned on;
wherein a first input end of the first logic control unit (210) is coupled to a first voltage source (300) via the first switch unit (220), and a second input end of the first logic control unit (210) is configured to receive a first power supply control signal, and an output end of the first logic control unit (210) is coupled to a control end of the first switch (111) of the first driving circuit (110); and
wherein a first input end of the second logic control unit (230) is coupled to the first voltage source (300) via the second switch unit (240), and a second input end of the second logic control unit (230) is configured to receive a second power supply control signal, and an output end of the second logic control unit (230) is coupled to a control end of the second switch (121) of the second driving circuit (120);
wherein the first switch unit (220) is configured to be turned off in response to the second power supply control signal being at a first level, and the second switch unit (240) is configured to be turned off in response to the first power supply control signal being at a first level; and
wherein the first logic control unit (210) is configured to output a first switch closing signal to close the first switch (111) in response to the first switch unit (220) being turned on and the first power supply control signal being a first level, and
the second logic control unit (230) is configured to output a second switch closing signal to close the second switch (121) in response to the second switch unit (240) being turned on and the second power supply control signal being at a first level.

2. The circuit of claim 1, wherein,
a control end of the second switch unit (240) is coupled to the second input end of the first logic control unit (210); and
a control end of the first switch unit (220) is coupled to the second input end of the second logic control unit (230).

3. The circuit of claim 1, wherein,
a control end of the second switch unit (240) is coupled to the output end of the first logic control unit (210) and is configured to be turned off in response to receiving the first switch closing signal; and
a control end of the first switch unit (220) is coupled to the output end of the second logic control unit (230) and is configured to be turned off in response to receiving the second switch closing signal.

4. The circuit of claim 1, wherein,
a control end of the second switch unit (240) is connected in series with the first switch (111) and is configured to be turned off in response to the first switch (111) being closed; and
a control end of the first switch unit (220) is connected in series with the second switch (121) and is configured to be turned off in response to the second switch (121) being closed.

5. The circuit according to claim 1, wherein the first logic control unit (210) comprises an optocoupler (C1), a first NPN-type transistor (T11), a first resistor (R11), a second resistor (R12), a third resistor (R13) and a fourth resistor (R14),
a first input end of the optical coupler (C1) being coupled to a first end of the fourth resistor (R14), a second end of the fourth resistor (R14) being coupled to the first switch unit (220), a second input end of the optical coupler (C1) being coupled to a collector electrode of the first NPN-type transistor (T11), and an output end of the optical coupler (C1) being coupled to the first switch (111), a base electrode of the first NPN-type transistor (T11) being coupled to a first end of the first resistor (R11) and a first end of the second resistor (R12), an emitter electrode of the first NPN-type transistor (T11) being coupled to a first end of the third resistor (R13), a second end of the first resistor (R11) being coupled to the second input end of the first logic control unit (210), a second end of the second resistor (R12) being grounded, and a second end of the third resistor (R13) being grounded.

6. The circuit of claim 5, wherein an emitter electrode of the first NPN-type transistor (T11) is coupled to a control end of the second switch unit (240).

7. The circuit according to claim 1, wherein the first switch unit (220) comprises a first P-channel depletion mode MOSFET (M11), a second NPN-type transistor (T12), a third NPN-type transistor (T13), a fifth resistor (R15), a sixth resistor (R16) and a seventh resistor (R17),
a source electrode of the first P-channel depletion type MOSFET (M11) being coupled to the first voltage source (300) and a first end of the seventh resistor (R17), a drain electrode of the first P-channel depletion type MOSFET (M11) being coupled to the first logic control unit (210), a gate electrode of the first P-channel depletion type MOSFET (M11) being coupled to a second end of the seventh resistor (R17), to a collector electrode of the second NPN type triode (T2) and to a collector electrode of the third NPN type triode (T3), a base electrode of the second NPN-type transistor (T2) being coupled to a first end of the fifth resistor (R15) and a first end of the sixth resistor (R16), an emission electrode of the second NPN-type transistor (T2) being coupled to a base electrode of the third NPN-type transistor (T3), an emitter electrode of the third NPN-type transistor (T3) being grounded; a second end of the sixth resistor (R16) being grounded; and a second end of the fifth resistor (R15) being coupled to a control end of the first switch unit (220).

8. The circuit of claim 1, wherein the first logic control unit (210) is further configured to not to output the first switch closing signal so as to turn off the first switch (111) in response to the first switch unit (220) being turned off and/or the first power supply control signal being at a second level.

9. The circuit of claim 8, wherein,
the circuit further comprises a power supply changeover switch;
the first driving circuit (110) further comprises a first actuator (112) configured to drive the power supply changeover switch to turn on one of the first power supply and the second power supply in response to the first switch (111) being closed;
and the second driving circuit (120) further comprises a second actuator (122) configured to drive the power supply changeover switch to turn on the other one of the first power supply and the second power supply in response to the second switch (121) being closed.

10. A dual power supply system comprising:
a first power supply, a second power supply, and
the circuit for a dual power supply system according to any one of claims 1 to 9, wherein the circuit for a dual power supply system is configured to selectively turn on the first power supply or the second power supply.
